# EUROPEAN PATENT APPLICATION

(11) **EP 1 244 217 A1**
(43) Date of publication of application: **25.09.2002**
(21) Application number: 01105581.1
(22) Date of filing: 06.03.2001
(51) Int. Cl.: H03M 1/10

(54) **Calibration of an A/D-converter**

(71) Applicant: Sony International (Europe) GmbH, 10785 Berlin (DE)
(72) Inventor: Ogawa, Naohiro, Sony International (Europe) GmbH, 85609 Aschheim (DE)
(74) Representative: Körber, Martin, Dipl.-Phys.

(57) **Abstract**

The present invention relates to the calibration of an AID-converter 4 of a processing device 1 for a wireless telecommunication terminal 2. Particular, the present invention relates to a processing device 1 comprising an A/D-converter 4, a memory means 6 in which calibration values for calibrating the digital output values output from the A/D-converter 4 are pre-stored an a computing means 5 for calibrating the digital output values on the basis of these pre-stored calibration values to obtain calibrated digital output values. Further, the present invention particularly relates to a method and a system for determining calibration values for an AID-converter 4 of such a processing device 1. Hereby, analogue input voltage values are supplied to the A/D-converter 4, digital output values of the A/D-converter 4 for different analogue input voltage values are detected and calibration values on the basis of the analogue input voltage values and the digital output values are computed. The computed calibration values are stored in a memory means of the processing device 1 to be used for the calibration during the operation of the processing device 1.

## Description

The present invention generally relates to the calibration of an analogue-to-digital converter (AID-converter) of a processing device for a wireless communication terminal. Particularly, the present invention relates to a processing device for a wireless telecommunication terminal and to a method and a system for determining calibration values for an A/D-converter of such a processing device.

A/D-converters are an essential element of modern digital processing. A/D-converters convert analogue input voltage values into digital values which are further processed by digital circuitry. The present patent application is directed to the calibration of A/D-converters being part of a processing device for a wireless communication terminal. Each wireless communication terminal, such as a cell phone, a personal digital assistant (PDA), and the like, comprises a processing device such as a microprocessor (also called base band processor), to control and manage the general functions of the terminal. The use of an A/D-converter in such a processing device is known and usually serves different essential purposes, such as detecting and controlling a charge voltage for charging a rechargeable battery of the terminal, monitoring the battery voltage, monitoring and compensating temperature effects and the like.

A problem is the sometimes very poor quality of the processing device and particularly the A/D-converter which deteriorates all related functions and thus effects the correct operation of the wireless communication terminal. The present application particularly is directed to an A/D-converter which ideally converts analogue input voltage values x linearly into digital output values y, i. e. according to the function y=x. However, some A/D-converters of available processing devices have an unexpected gain, so that e. g. more than 30 mV error at more than 1.4 V analogue input voltage occurs. The consequence is that a A/D-converter and the processing device are working in a very unreliable way.

The object of the present invention is therefore to provide a processing device for a wireless telecommunication terminal, and a method and a system for determining calibration values for an A/D-converter of such a processing device, which allow a reliable and correct operation of the A/D-converter and thus the processing device.

The above object is achieved by a processing device for a wireless telecommunication terminal according to claim 1. The processing device according to the present invention comprises an A/D-converter for converting analogue input voltage values into digital values, a memory means in which calibration values for calibrating the digital output values output from the A/D-converter are pre-stored, and a computing means for calibrating the digital values output from the analogue-to-digital converter on the basis of the calibration values to obtain calibrated output values.

The calibration of the A/D-converter can thus be easily implemented on the processing device, since the necessary elements are usually already part of the processing device and the necessary functionality can be easily implemented by a software programme. During operation of the processing device and the A/D-converter, the pre-stored calibration values are read out from the memory means and used by the computing means to calibrate and thus correct the digital output values output from the A/D-converter so that correct and precise digital output values are obtained and can be used for further processing.

Advantageously, the computing means, on the basis of the calibration values, performs a linear calibration of the digital output values output from the A/D-converter to obtain the calibrated output values. In this case, the linear calibration is advantageously based on the equation y'*=*(1/A×y*-*(B/A),A and B being said calibration values, y being the digital output values of the A/D-converter and y' being the resulting calibrated output values obtained in the computing means. The resulting calibrated output values are then used for further processing corresponding to the required functionality in the processing device.

Further advantageously, memory means in which the calibration values are pre-stored is a flash memory in order to ensure quick and reliable operation.

The above object is further achieved by a method for determining calibration values for an A/D-converter of a processing device of a wireless telecommunication terminal according to claim 5, whereby said A/D-converter converts analogue input voltage values into digital values. The method according to the present invention comprises the steps of supplying analogue input voltage values to the A/D-converter, detecting digital output values of the A/D-converter for different analogue input voltage values, computing calibration values for the A/D-converter on the basis of the analogue input voltage values and the digital output voltage values, and storing the calibration values in a memory means of the processing device.

The above object is further achieved by a system for determining calibration values for an A/D-converter of a processing device for a wireless telecommunication terminal according to claim 14, said A/D-converter converting analogue input voltage values into digital values. The system according to the present invention comprises supply means for supplying analogue input voltage values to the A/D-converter, computing means for detecting digital output values of the A/D-converter for different analogue input voltage values, for computing calibration values for the A/D-converter on the basis of the analogue input voltage values and the digital output values and for storing the calibration values in a memory means of the processing device.

The method and the system for determining calibration values according to the present invention are e. g. used in a factory system, where the wireless telecommunication terminals are manufactured and/or assembled. Before, during or after a respective processing device, such as a microprocessor or the like, is implemented in a wireless telecommunication terminal, the calibration values for the A/D-converter of the processing device can be determined and stored in the memory means of the processing device. In this way it can be ensured that the processing devices of the wireless telecommunication terminals leaving the factory operate in a proper and correct way. Since all A/D-converters of each processing device are calibrated separately, individual differences between the different A/D-converters and thus the processing devices can be equilibrated effectively.

Advantageously, the computing means computes the calibration values on the basis of a linear function. The calibration on the basis of a linear function has proven to be a simple but very effective and precise way for calibrating the conversion error produced by the A/D-converter since the deviation in the A/D-conversion does not seem to depend on temperature. Although the A/D-conversion does not follow the ideal function y=x, it seems like the A/D-converter of the presently addressed environment does not have a non-linear function, but a function which can be approximated as a linear function. An advantageous approximation of the linear function of the A/D-converter is y=A×x+B, x being the analogue input voltage values, y being the digital output values, and A and B being the calibration values. In the calibration procedure, the computing means advantageously detects several digital output values of the A/D-converter for each of the different analogue input voltage values and calculates an average value from the several digital output values. This has the advantage of a more reliable calculation of calibration values. Further, the computing means advantageously computes the calibration value B as an average value from several detected digital output values at an analogue input voltage value of 0 mV. Assuming the above mentioned linear function for the A/D-converter, the calibration value B can easily be calculated as the y value at which the linear function crosses the x=0 value. Further advantageously, the computing means computes the calibration value A on the basis of a ratio of an average analogue input voltage value and an average digital output value for at least some of the different analogue input voltage values. Hereby, the computing means advantageously computes the calibration value A on the basis of an average value of several of said ratios. Thus, by calculating the gradient or even an average gradient of the above mentioned linear function, the calibration value A can be calculated in a simple way. Before the ratio is computed, the computing means advantageously may compute a difference value for each pair of the average analogue input voltage values and average digital output values and compare the computed difference value with a predetermined plausibility threshold value. Hereby, the plausibility of the assumption of the linear function can be enhanced. Further advantageously, the computing means, after computing the calibration values A and B, checks the accuracy of the calibration by computing the difference between a calibrated output value and analogue input voltage value. Hereby, the accuracy of the assumption of the above mentioned linear function can be checked and monitored.

In the following description, an advantageous embodiment of the present invention is described in relation to the enclosed drawings, in which
Fig. 1 shows a diagram in which the calibration of the A/D-converter according to the present invention is explained on the basis of mathematical functions, and
Fig. 2 shows a schematic block diagram of a wireless telecommunication terminal comprising a processing device according to the present invention and connected to a system for determining calibration values according to the present invention.

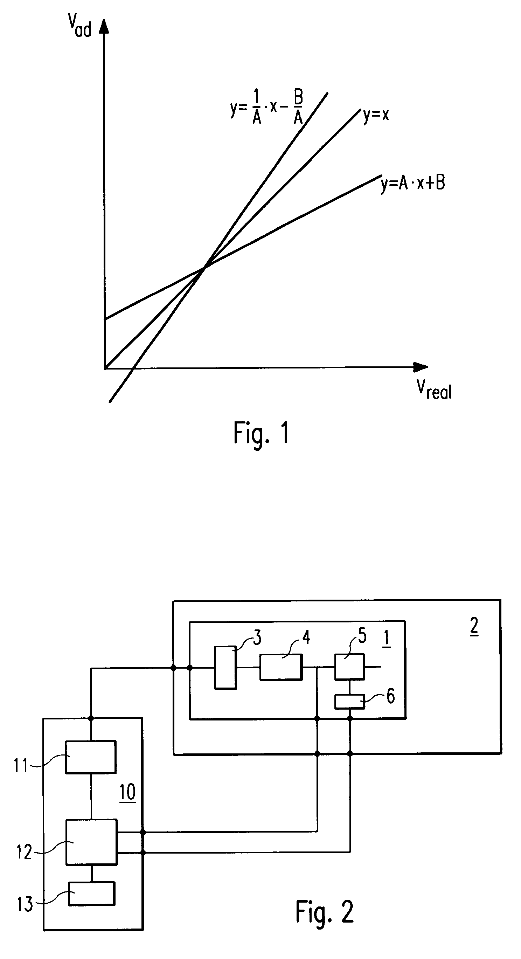

Fig. 1 shows a diagram with different functions for the analogue-to-digital conversion in an A/D-converter according to the present invention. Hereby, the horizontal axis (x-axis) represents the analogue input voltage values input to the A/D-converter, and the vertical axis (y-axis) represents the digital output values output by the A/D-converter. Ideally, the A/D-converter performs an analogue-to-digital conversion according to the function y=x. It has been found, however, that certain types of A/D-converters show an unexpected gain above a certain analogue input value, as e. g. above 1.4 V. When studying the phenomenon, it has been found that the real conversion function of this type of A/D-converters can be approached by a linear function y=A×x+B, A and B being calibration values. In other words, A/D-converters of this specific type showing an unexpected gain perform an analogue-to-digital conversion which is deviated from the ideal function y=x, whereby the actual conversion performed by these A/D-converters corresponds to the function y=A×x+B. A and B are calibration values which are specific for each single one of these A/D-converters. The general linear characteristic, however, seems to be common for this type of A/D-converters.

Thus, the real digital output values output by such an A/D-converter can be represented by y=A×x+B, x being the analogue input voltage values. According to the present invention, these output values can be compensated and corrected according to the present invention by an inverse function y'=(1/A)×y-(B/A), A and B being the calibration values, y being the real digital output values of the A/D-converter and y' being the resulting calibrated output values. The insertion of the above described assumed linear function y=A×x+B into the inverse function for y' gives the ideal conversion function y'=x. Therefore, a correction and compensation of the deviated and erroneous conversion function of such an A/D-converter can be achieved in a simple but effective way.

It is sufficient to determine and calculate the calibration value A and B for each of the A/D-converters, e. g. during or after manufacturing or assembling of the device in which the A/D-converter is to be used and to store the corresponding individual calibration values A and B in a memory means of the processing device, in which the A/D-converter is implemented, so that the digital output values from the A/D-converter can be corrected and calibrated so that correct and calibrated output values can be obtained.

In Fig. 2, a schematic block diagram of a processing device 1 implemented in a wireless telecommunication terminal 2 is shown, whereby the processing device 1 comprises an A/D-converter 4 of the above mentioned kind. The wireless telecommunication terminal 2 and the processing device 1 are connected to a factory system 10 according to the present invention, which allows to determine other calibration values A and B. It is to be understood, however, that in Fig. 2 only elements of the processing device 1 and the factory system 10 are shown, which are important for the explanation of the present invention. Other necessary elements for the operation of the processing device 1 and the factory system 10 as well as the wireless telecommunication terminal 2 are omitted for the sake of clarity.

The wireless telecommunication terminal 2 can e. g. be a mobile terminal of a wireless telecommunication system, such as the GSM or the UMTS system, a personal digital assistant (PDA) or the like. The processing device 1 is e. g. a microprocessor such as a baseband-processor or the like and controls and manages the essential functions of the wireless telecommunication terminal 2. In operation, the wireless telecommunication terminal 2 is not connected to the factory system 10 as shown in Fig. 2, since the factory system 10 only serves for the determination of the calibration values A and B for calibrating and compensating the A/D-converter 4. The A/D-converter 4 of the processing device 1 is connected to a multiplexer 3, through which analogue input voltage values are supplied to the A/D-converter 4 to be converted into digital values. The multiplexer 3 serves for selecting and switching different kinds of analogue input voltage values to the A/D-converter 4, e. g. voltage values of a temperature detecting means, charge voltage values of the charge status of a chargeable battery of the wireless telecommunication terminal 2, voltage values of a charging device connected to the chargeable battery, and the like. The digital output values output from the A/D-converter 4 are supplied to a computing means 5, which on the basis of calibration values A and B stored in a memory means 6, calibrates and corrects the digital output values obtained from the A/D-converter 4 into calibrated and corrected digital output values, which can then be further processed in the processing device 1. Hereby, the computing means 5 uses the above mentioned equation y'=(1/A)×y-(B/A) for calibrating the digital output values y from the A/D-converter 4. y' are then the calibrated digital output values to be further processed. The memory means 6 can e. g. be a flash memory or the like.

In operation, the computing means 5 therefore continuously corrects and calibrates the digital output values output from the A/D-converter 4 on the basis of the calibration values A and B which are pre-stored in the memory means 6. The calibration values A and B had previously being computed and stored in the memory means 6 during or after the manufacture and/or assembly of the processing device 1 or the wireless telecommunication terminal 2. The calculation and determination of the calibration values A and B is explained in detail in the following description of the operation of the factory system 10.

The factory system 10 is located in the factory where the processing device 1 and the wireless telecommunication terminal 2 are manufactured and/or assembled and serves for determining the calibration values A and B for the A/D-converter 4. It has to be understood, however, that the method for determining the calibration values A and B according to the present invention does not necessarily has to be performed by the factory system 10, but can be performed in any other manual or automatic way.

The factory system 10 comprises a power supply means 11 for supplying analogue input voltage values Vᵣₑₐₗ to the A/D-converter 4 through the multiplexer 3. For this purpose, a power supply means 11 is connected to a corresponding input terminal of the multiplexer 3. The analogue input voltage values from the power supply means 11 are highly accurate and stabilized voltage values to ensure a proper and correct calibration of the A/D-converter. The analogue input voltage values supplied from the power supply means 11 to the A/D-converter 4 are also supplied to a computing means 12 of the factory system where they are used to calculate the calibration values A and B. Alternatively, the power supply means 11 could be an external but highly stabilized power supply unit which supplies highly accurate input voltage values to the A/D-converter 4. These highly accurate voltage values could be measured by a corresponding measuring means of the factory system and then supplied to the computing means 12 to be used for the calculation of the calibration values A and B.

The computing means 12 of the factory system 10 is connected to the output of the A/D-converter 4 and thus receives the digital output values V_{ad}, which are not yet calibrated, from the A/D-converter 4. Further, the computing means 12 of the factory system 10 is connected to the memory means 6 of the processing device 1 in order to store the computed and calculated calibration values A and B therein.

In a first measurement procedure, the factory system 10 determines the calibration value B. Hereby, several different analogue input voltage values Vᵣₑₐₗ from the power supply means 11 are used and supplied to the A/D-converter 4. For each of the different analogue input voltage values Vᵣₑₐₗ which can e. g. be 0 mV, 650 mV, 1000 mV, 1350 mV, 1650 mV, a number, e.g. 10, digital output values V_{ad} of the A/D-converter 4 is measured and averaged in order to obtain an averaged digital output value V_{ad_ave} for each of the analogue input voltage values Vᵣₑₐₗ, also an average value V_{real_ave} is calculated by the computing means 12. This averaging allows to reduce the influence of noise.

When measuring the input and the output values of the A/D-converter 4 and during the entire calibration procedure, the processing device 1 should be switched into a test mode, in which all internal bias current sources and the like are switched off so that the measurement and the calculation of the calibration values A and B is not disturbed. Then, as stated above, for each of the e. g. five different analogue input voltage values Vᵣₑₐₗ, a number, as e. g. 10, different measurements of the digital output values V_{ad} output from the A/D-converter 4 should be performed. Between the switching from one analogue input voltage value to the next analogue input voltage value a certain delay time should be respected in order to allow a stabilization of the voltage values supplied by the power supply means 11.

The obtained average input voltage values V_{real_ave} and output values V_{ad_ave} are read by the computing means 12 and stored in the storage means 13 of the factory system 10. As can be seen from Fig. 1, the calibration value B is the value at which the line of the real and uncalibrated conversion function y=A×x+B of the AID-converter 4 crosses the vertical axis at 0 mV input voltage value. Thus, the calibration value B is determined as the digital output value V_{ad_ave} at the analogue input voltage value V_{real_ave} 0 mV. The corresponding value is stored as the calibration value B in the storage means 13 of the factory system 10 and also in the memory means 6 of the processing device 1.

In a second measurement procedure, the calibration value A is calculated. Hereby, the computing means 12 calculates the absolute value of the difference V_{real_ave} -V_{ad_ave} for the analogue input voltage values different from 0 mV i. e. in the above example for the analogue input voltage values 650 mV, 1000 mV, 1350 mV and 1650 mV. If the absolute value |V_{diff'}| of the calculated difference values is larger than 10 mV, a ratio Aᵣₐₜᵢₒ=V_{ad_ave}/V_{real_ave} is calculated for every analogue input voltage value. The assumption that the real conversion function of the A/D-converter 4 corresponds to a linear function also means that the calculated ratio Aᵣₐₜᵢₒ should be almost constant for each of the analogue input voltage values different from 0 mV.

The different ratios Aᵣₐₜᵢₒ are then averaged, i. e. that in the above example four different Aᵣₐₜᵢₒ values for the examples 650 mV, 1000 mV, 1350 mV and 1650 mV are averaged so that an averaged ratio value A is obtained. This average ratio value A is the calibration value A. The corresponding value is stored in the storage means 13 of the factory system 10 as well as in the memory means 6 of the processing device 1. Also, the difference values |V_{diff}| and the ratio values Aᵣₐₜᵢₒ are stored in the storage means 13 of the factory system 10 so that these values can be used to check if the assumption of the linear function is reasonable can be checked.

In a third measurement procedure for checking the plausibility and the error of the obtained result for the calibration values A and B is checked. Hereby, the computing means 12 calculates a compensation value V_{comp} for each of the averaged digital output values V_{ad_ave} according to the function V_{comp}=(1/A)×V_{ad_ave}-B/A. Then, an error value Vₑᵣᵣ is calculated as the difference between the calculated compensation value V_{comp} and the corresponding analogue input voltage value V_{real_ave} according to the function Vₑᵣᵣ=V_{real_ave}-V_{comp}. If the absolute value of the error value Vₑᵣᵣ is smaller than a predetermined plausibility value, as e. g. 3 mV, then the assumption was correct and the calibration values A and B can be used to calibrate and compensate the A/D-conversion by the A/D-converter 4. If, on the other hand, the absolute value of the error value Vₑᵣᵣ is larger than the predetermined threshold value, i. e. that the assumption was not correct enough and that the calibration values A and B cannot be used to obtain a proper and correct calibrated output value from the A/D-converter 4. Then, the processing device 1 and the A/D-converter 4 should be checked again or should not be used.

As described above, the present invention provides a simple and effective way of providing and using calibration values for an A/D-converter of a processing device for a wireless telecommunication terminal. It has been proved that the assumption of a linear function for the A/D-conversion gives good results in the calibration procedure and an almost ideal A/D-conversion according to the function y=x can be obtained by using the calibration values A and B as described above. Advantageously, it seems like the A/D-conversion of the A/D-converters of the type described above is not temperature dependent, so that a temperature compensation is not necessary. If necessary, however, a further temperature compensation could be implemented into the above described calibration procedure. Further, the impedance of the multiplexer 3 located in front of the A/D-converter 4, at least for the evaluated processing devices 1, has a linearity for the analogue input voltage values. If this would not be the case, an additional error would have to be taken into account.

## Claims

1. Processing device (1) for a wireless telecommunication terminal (2), with
an analog-to-digital converter (4) for converting analog input voltage values into digital values,
a memory means (6) in which calibration values for calibrating the digital output values output from the analog-to-digital converter are prestored, and
a computing means (5) for calibrating the digital output values output from the analog-to-digital converter on the basis of the calibration values to obtain calibrated digital output values.

2. Processing device (1) according to claim 1,
**characterized in,**
**that** said computing means (5), on the basis of said calibration values, performs a linear calibration of said digital values output from the analog-to-digital converter (4).

3. Processing device (1) according to claim 2,
**characterized in,**
**that** said linear calibration is based on the equation y'=(1/A)y-(B/A), A and B being said calibration values, y being the digital output values of the analog-to-digital converter (4), and y' being the resulting calibrated output values obtained in the computing means (5).

4. Processing device (1) according to claim 1, 2 or 3
**characterized in,**
**that** said memory means (6) is a flash memory.

5. Method for determining calibration values for an analog-to-digital converter (4) of a processing device (1) for a wireless telecommunication terminal (2), said analog-to-digital converter (4) converting analog input voltage values into digital values, comprising the steps of
supplying analog input voltage values to said analog-to-digital-converter (4),
detecting digital output values of said analog-to-digital converter (4) for different analog input voltage values,
computing calibration values for said analog-to-digital-converter (4) on the basis of said analog input voltage values and said digital output voltage values, and
storing said calibration values in a memory means (6) of said processing device (1).

6. Method according to claim 5,
**characterized in,**
**that** in said computing step said calibration values are computed on the basis of a linear function.

7. Method according to claim 6,
**characterized in,**
**that** said linear function is y=Ax+B, x being said analog input voltage values, y being said digital output values, and A, B being said calibration values.

8. Method according to claim 7,
**characterized in,**
**that** in said detecting step several digital output values of said analog-to-digital converter are detected for each of said different analog input voltage values, and that in said computing step an average value is calculated from said several digital output values.

9. Method according to claim 8,
**characterized in,**
**that** said calibration value B is computed as an average value from several detected digital output values at an analog input value of 0 mV.

10. Method according to claim 8 or 9,
**characterized in,**
**that** said calibration value A is computed on the basis of a ratio of an average analog input voltage value and an average digital output value for at least some of said different analog input voltage values.

11. Method according to claim 10,
**characterized in,**
**that** said calibration value A is computed on the basis of an average value of several of said ratios.

12. Method according to claim 10 or 11,
**characterized in,**
**that** before said ratio is computed, a difference value for each pair of said average analog input voltage values and average digital output values is computed and compared with a predetermined plausibility threshold value.

13. Method according to one of the claims 7 to 12,
**characterized in,**
**that** after computing said calibration values A and B the accuracy of the calibration is checked by computing a difference between a calibrated output value and an analog input voltage value.

14. System (10) for determining calibration values for an analog-to-digital converter (4) of a processing device (1) for a wireless telecommunication terminal (2), said analog-to-digital converter (4) converting analog input voltage values into digital values, comprising supply means (11) for supplying analog input voltage values to said analog-to-digital-converter,
computing means (12) for detecting digital output values of said analog-to-digital converter (4) for different analog input voltage values,
for computing calibration values for said analog-to-digital-converter (4) on the basis of said analog input values and said digital output voltage values, and
for storing said calibration values in a memory means (6) of said processing device (1).

15. System (10) according to claim 14,
**characterized in,**
**that** said computing means (12) computes said calibration values on the basis of a linear function.

16. System (10) according to claim 15,
**characterized in,**
**that** said linear function is y=Ax+B, x being said analog input voltage values, y being said digital output values, and A, B being said calibration values.

17. System (10) according to claim 16,
**characterized in,**
**that** said computing means (12) detects several digital output values of said analog-to-digital converter for each of said different analog input voltage values and calculates an average value from said several digital output values.

18. System (10) according to claim 17,
**characterized in,**
**that** said computing means (12) computes said calibration value B as an average value from several detected digital output values at an analog input value of 0 mV.

19. System (10) according to claim 17 or 18,
**characterized in,**
**that** said computing means (12) computes said calibration value A on the basis of a ratio of an average analog input voltage value and an average digital output value for at least some of said different analog input voltage values.

20. System (10) according to claim 19,
**characterized in,**
**that** said computing means (12) computes said calibration value A on the basis of an average value of several of said ratios.

21. System (10) according to claim 19 or 20,
**characterized in,**
**that** said computing means (12), before said ratio is computed, computes a difference value for each pair of said average analog input voltage values and average digital output values and compares the computed difference value with a predetermined plausibility threshold value.

22. System (10) according to one of the claims 16 to 21,
**characterized in,**
**that** said computing means (12), after computing said calibration values A and B, checks the accuracy of the calibration by computing a difference between a calibrated output value and an analog input voltage value.
